# FASCICULE DE BREVET EUROPEEN

(11) **EP 4 548 717 B1**
(45) Date de publication et mention de la délivrance du brevet: **01.07.2026**
(21) Numéro de dépôt: 23737955.7
(22) Date de dépôt: 29.06.2023
(51) Int. Cl.: H05K 7/14, H05K 7/20

(54) **CELLULE DE COMMUTATION**
SCHALTZELLE
SWITCHING CELL

(30) Priorité: 30.06.2022 FR 2206660
(43) Date de publication de la demande: 07.05.2025
(73) Titulaire: Valeo Electrification, 95892 Cergy Pontoise (FR)
(72) Inventeur: GILET, Olivier, 95892 Cergy Pontoise (FR); LOPES, Christophe, 95892 Cergy Pontoise (FR); HECHT, Michael, 91056 Erlangen (DE)
(74) Mandataire: Valeo Powertrain Systems
(86) Numéro de dépôt international: PCT/EP2023/067931
(87) Numéro de publication internationale: WO 2024/003316

(56) Documents cités:
- CN-A- 105 939 118
- CN-A- 110 429 830
- CN-A- 113 783 365
- US-A1- 2008 024 959
- US-A1- 2013 223 009
- US-B2- 9 241 413

## Description

### Domaine technique de l'invention

La présente invention concerne une cellule de commutation, en particulier pour un onduleur associé à une machine électrique.

### Arrière-plan technologique

De l'état de la technique, on connaît les documents US2013/223009 et CN113783365 décrivant respectivement un convertisseur de puissance et un redresseur pour automobile. Par ailleurs, on connaît également une cellule de commutation comportant :
- des modules de puissance ;
- une première barre omnibus, dite barre omnibus supérieure, et une deuxième barre omnibus, dite barre omnibus inférieure, connectées à chacun des modules de puissance afin de distribuer à ces derniers une tension continue, la barre omnibus supérieure et la barre omnibus inférieure comprenant chacune une première plaque ; et,
- au moins un condensateur avec deux bornes respectivement soudées à la première et à la deuxième barre omnibus.

Le soudage du condensateur nécessite l'utilisation d'appareils pouvant être volumineux et un accès aux barres omnibus. Ainsi, à cause des contraintes du soudage, les barres omnibus sont généralement placées à distance l'une de l'autre.

Cependant, il est généralement souhaité que la cellule de commutation soit la plus compacte possible.

Il peut ainsi être souhaité de prévoir une cellule de commutation qui permette de s'affranchir d'au moins une partie des problèmes et contraintes précités.

### Résumé de l'invention

Il est proposé, selon un premier aspect de l'invention, une cellule de commutation comportant :
- des modules de puissance ;
- une première barre omnibus, dite barre omnibus supérieure, et une deuxième barre omnibus, dite barre omnibus inférieure, connectées à chacun des modules de puissance afin de distribuer à ces derniers une tension continue, la barre omnibus supérieure et la barre omnibus inférieure comprenant chacune une première plaque ; et,
- au moins un condensateur avec deux bornes respectivement soudées à la première et à la deuxième barre omnibus ;
caractérisée en ce que la barre omnibus supérieure et la barre omnibus inférieure sont empilées l'une sur l'autre et en ce qu'elle comporte un support de la barre omnibus supérieure et inférieure comportant un fond sur lequel s'étendent les premières plaques des barres omnibus empilées, en ce que la première plaque de la barre omnibus inférieure présente une ouverture laissant apparente une partie, dite de connexion, de la première plaque de la barre omnibus supérieure et en ce que le fond présente une ouverture laissant apparente une partie, dite de connexion, de la première plaque de la barre omnibus inférieure et au moins une partie de l'ouverture de la première plaque de la barre omnibus inférieure, afin de connecter, d'une part, une première borne du condensateur à la partie de connexion de la barre omnibus inférieure au travers de l'ouverture du fond et, d'autre part, une deuxième borne du condensateur à la partie de connexion de la barre omnibus supérieure au travers de l'ouverture du fond et de l'ouverture de la barre omnibus inférieure.

Grâce à l'invention, les barres omnibus sont empilées et prennent donc peu de place, tout en étant facilement connectées au condensateur.

L'invention, selon son premier aspect, peut en outre comporter l'une ou plusieurs des caractéristiques optionnelles suivantes, selon toute combinaison techniquement possible, à condition que ces combinaisons soient couvertes par les revendications.

De façon optionnelle, les deux bornes du condensateur sont respectivement soudées à la première plaque de la barre omnibus supérieure et à la première plaque de la barre omnibus inférieure.

De façon optionnelle, la première plaque de la barre omnibus supérieure et la première plaque de la barre omnibus inférieure sont planes.

De façon optionnelle, la partie de connexion de la première plaque de la barre omnibus inférieure présente une épaisseur réduite par rapport au reste de la première plaque de la barre omnibus inférieure.

De façon optionnelle également, la première plaque de la barre omnibus supérieure présente un bossage s'étendant dans l'ouverture de la première plaque de la barre omnibus inférieure.

De façon optionnelle également, le bossage présente une paroi inférieure plane de connexion présentant une épaisseur réduite par rapport au reste de la première plaque de la barre omnibus supérieure.

De façon optionnelle également, le support présente un pion de fixation et la première plaque de la barre omnibus supérieure présente une ouverture de réception du pion de fixation, ce dernier étant bouterollé pour fixer la première plaque de la barre omnibus au support.

De façon optionnelle également, la première plaque de la barre omnibus inférieure est maintenue entre la première plaque de la barre omnibus supérieure et le support.

De façon optionnelle également, la barre omnibus inférieure est conçue pour présenter un potentiel électrique haut et la barre omnibus supérieure est conçue pour présenter un potentiel électrique bas.

De façon optionnelle également, le support présente un pion de positionnement de la première plaque de la barre omnibus inférieure.

De façon optionnelle également, le pion de positionnement est agencé de manière à maintenir la première plaque de la barre omnibus inférieure en place perpendiculairement au pion de fixation.

De façon optionnelle également, le pion de positionnement s'étend parallèlement au pion de fixation.

De façon optionnelle également, chaque module de puissance implémente un bras de commutation conçu pour réaliser une conversion entre la tension continue et une tension alternative.

De façon optionnelle également, la cellule de commutation comprend en outre un circuit de refroidissement des modules de puissance, ledit circuit de refroidissement comportant un boîtier de refroidissement définissant un canal d'écoulement d'un liquide de refroidissement, le boîtier de refroidissement présentant une face supérieure de refroidissement et une face inférieure de refroidissement, toutes les deux refroidies par l'écoulement du liquide de refroidissement dans le canal, les modules de puissance étant plaqués contre la face supérieure de refroidissement pour être refroidis.

De façon optionnelle également, la première plaque de la barre omnibus supérieure est en contact thermique avec la face inférieure de refroidissement.

De façon optionnelle, le boîtier de refroidissement comprend en outre un conduit d'entrée du liquide de refroidissement dans le boîtier de refroidissement et un conduit de sortie du liquide de refroidissement hors du boîtier de refroidissement, le conduit d'entrée et le conduit de sortie présentant chacun un segment, le segment du conduit d'entrée et le segment du conduit de sortie se projetant sensiblement parallèlement l'un à l'autre dans le même sens.

De façon optionnelle, une première couche isolante est intercalée entre les premières plaques des barres omnibus supérieure et inférieure.

De façon optionnelle, une deuxième couche isolante est positionnée entre le dessus de la première plaque de la barre omnibus supérieure et la face inférieure du boîtier de refroidissement.

Il est également proposé selon un deuxième aspect de l'invention, un onduleur comprenant une cellule de commutation selon le premier aspect de l'invention.

De façon optionnelle, l'onduleur comprend en outre un boîtier dans l'intérieur duquel est positionnée la cellule de commutation, le boîtier présentant deux ouvertures de passage, le segment du conduit d'entrée étant inséré dans une des deux ouvertures de passage et le segment du conduit de sortie étant inséré dans l'autre des deux ouvertures de passage.

Il est également proposé, selon un troisième aspect de l'invention, un engin de mobilité comprenant une cellule de commutation selon le premier aspect de l'invention ou un onduleur selon le deuxième aspect de l'invention.

Un engin de mobilité est par exemple un véhicule terrestre à moteur, un train, un aéronef ou un drone.

Un véhicule terrestre à moteur est par exemple un véhicule automobile, une moto, un vélo motorisé ou un fauteuil roulant motorisé.

### Brève description des figures

L'invention sera mieux comprise à l'aide de la description qui va suivre, donnée uniquement à titre d'exemple et faite en se référant aux dessins annexés dans lesquels :
- la figure 1 est une vue en coupe d'un exemple d'un cellule de commutation dans laquelle l'invention est mise en œuvre,
- la figure 2 est une vue en trois dimensions de la cellule de commutation,
- la figure 3 est une vue en trois dimensions de la cellule de commutation, avec une carte de contrôle, un capot et un système de ressort enlevés,
- la figure 4 est une vue en trois dimensions d'un condensateur de la cellule de commutation,
- la figure 5 est un schéma-bloc d'un procédé de fabrication du condensateur,
- la figure 6 est une vue en trois dimensions et en coupe de barres omnibus et d'un support des barres omnibus de la cellule de commutation,
- la figure 7 est une vue en trois dimensions des barres omnibus, de leur support et de condensateurs de la cellule de commutation, où des pions de fixation sont visibles, avant leur bouterollage,
- la figure 8 est une vue similaire à la figure 7, après bouterollage des pions de fixation,
- la figure 9 est une vue en trois dimensions du dessous du support de barres omnibus,
- la figure 10 est une vue en trois dimensions et en coupe des barres omnibus, de leur support et des condensateurs de la cellule de commutation, montrant la connexion des condensateurs aux barres omnibus,
- la figure 11 est un schéma-bloc d'un procédé de soudage du condensateur,
- la figure 12 est une vue en coupe d'un des condensateurs, des barres omnibus et de leur support, illustrant une étape du procédé de soudage,
- la figure 13 est une vue en trois dimensions de broches de contrôle de modules de puissance de la cellule de commutation, et de leur environnement,
- la figure 14 est une vue en trois dimensions d'une variante des broches de contrôle,
- la figure 15 est une vue en trois dimensions illustrant des excroissances des broches de contrôle de la figure 14,
- la figure 16 est un schéma-bloc d'un procédé de fabrication de la cellule de commutation,
- la figure 17 est une vue en coupe tridimensionnelle d'un système électrique, tel qu'un onduleur, recevant la cellule de commutation, et
- la figure 18 est un schéma bloc d'un procédé d'assemblage du système électrique.

### Description détaillée de l'invention

Dans la description et les revendications qui vont suivre, les différentes pièces et éléments seront positionnés les uns par rapport aux autres dans l'espace en référence à un repère orthogonal XYZ, d'orientation arbitraire, comportant une direction X, une direction Y, et une direction Z. Par soucis de clarté, la direction X sera appelée direction gauche-droite (sur les figures, la flèche de la direction X est orientée vers la gauche), la direction Y appelée direction avant-arrière (sur les figures, la flèche de la direction Y est orientée vers l'arrière) et la direction Z appelée direction bas-haut (sur les figures, la flèche de la direction Z est orientée vers le haut).

En référence aux figures, un exemple d'une cellule de commutation 100 dans laquelle l'invention est mise en œuvre, va à présent être décrit.

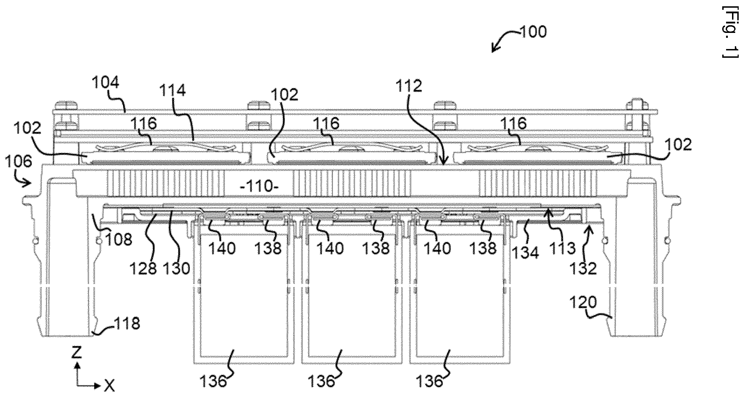

En référence à la figure 1, la cellule de commutation 100 comporte tout d'abord plusieurs modules de puissance 102. Dans l'exemple illustré, trois modules de puissance 102 sont prévus. Les modules de puissance 102 sont par exemple placés les uns à côtés des autres.

La cellule de commutation 100 comporte en outre une carte électronique 104 de contrôle des modules de puissance 102. La carte électronique de contrôle 104 s'étend par exemple au-dessus des modules de puissance 102.

La cellule de commutation 100 comporte en outre un circuit 106 de refroidissement des modules de puissance 102.

Le circuit de refroidissement 106 comporte un boîtier de refroidissement 108 définissant un canal 110 d'écoulement du liquide de refroidissement. Le boîtier de refroidissement 108 présente une face supérieure de refroidissement 112 et une face inférieure de refroidissement 113, toutes les deux refroidies par l'écoulement du liquide de refroidissement dans le canal 110. Les modules de puissance 102 sont ainsi plaqués contre la face supérieure de refroidissement 112 pour être refroidis.

Pour maintenir les modules de puissance 102 plaqués contre la face supérieure de refroidissement 112, la cellule de commutation 100 comporte par exemple tout d'abord un capot 114 s'étendant au-dessus des modules de puissance 102, par exemple entre la carte électronique de contrôle 104 et les modules de puissance 102. Le capot 114 est fixé au boîtier de refroidissement 108, par exemple par des vis. La cellule de commutation 100 comporte en outre un système de ressort intercalé entre le capot 114 et les modules de puissance 102. Ce système de ressort est ainsi conçu pour prendre appui sur le capot 114 et pousser les modules de puissance 102 vers la face supérieure de refroidissement 112. Le système de ressort comporte par exemple, pour chaque module de puissance 102, une lame flexible 116, comprimée entre le capot 114 et le module de puissance 102.

Le circuit de refroidissement 106 comporte en outre un conduit 118 d'entrée du liquide de refroidissement dans le boîtier de refroidissement 108 et un conduit 120 de sortie du liquide de refroidissement hors du boîtier de refroidissement 108. Les conduits 118, 120 sont par exemple situés respectivement à droite et à gauche du boîtier de refroidissement 108 et se projettent verticalement vers le bas de ce dernier.

La cellule de commutation 100 comporte en outre une barre omnibus dite positive 128 et une barre omnibus dite négative 130, empilées l'une sur l'autre. L'une des deux barres omnibus 128, 130 forme ainsi une barre omnibus inférieure, tandis que l'autre forme une barre omnibus supérieure. La barre omnibus dite positive 128 et la barre omnibus dite négative 130 comprenne chacune une première plaque et une deuxième plaque, la première plaque étant en continuité de matière avec la deuxième plaque.

Dans l'exemple décrit, la première plaque de chacune des deux barres omnibus est une plaque plane.

Par exemple, la première plaque de la barre omnibus positive 128 s'étend sous la première plaque de la barre omnibus négative 130 et la première plaque de la barre omnibus négative 130 s'étend sous le boîtier de refroidissement 108. Ainsi, la barre omnibus positive 128 forme la barre omnibus inférieure et la barre omnibus négative 130 forme la barre omnibus supérieure. La configuration inverse est également possible.

En outre, la seconde plaque de la barre omnibus positive 128 et la seconde plaque de la barre omnibus négative 130 s'étendent le long d'un côté du boîtier de refroidissement 108.

La barre omnibus positive 128 est conçue pour présenter un potentiel électrique haut, tandis que la barre omnibus négative 130 est conçue pour présenter un potentiel électrique bas, plus bas que le potentiel électrique haut, de sorte que les barres omnibus 128, 130 sont conçues pour présenter, entre elles, une tension continue U_{DC}.

Les barres omnibus 128, 130 sont toutes les deux connectées, par l'intermédiaire d'au moins un terminal de connexion s'étendant à partir de leur seconde plaque, à chacun des modules de puissance 102 afin de distribuer à ces derniers la tension continue U_{DC}.

Pour maintenir en place les barres omnibus 128, 130, la cellule de commutation 100 comporte par exemple un support 132, en particulier en matériau isolant électrique, par exemple en plastique. Plus précisément, le support 132 présente un fond 134 sur lequel s'étendent les premières plaques des barres omnibus 128, 130. Le support 132 est fixé au boîtier de refroidissement 108 de sorte que les premières plaques des barres omnibus 128, 130 s'étendent entre la face inférieure de refroidissement 113 du boîtier de refroidissement 108 et le fond 134 du support 132. Les barres omnibus 128, 130 peuvent ainsi être refroidies au travers de la face inférieure de refroidissement 113.

La cellule de commutation 100 comporte en outre des condensateurs 136 comportant chacun deux bornes 138, 140 respectivement connectées aux barres omnibus 128, 130 pour recevoir la tension continue U_{DC}. Ces condensateurs 136 sont conçus pour lisser la tension continue U_{DC} et sont généralement appelés en anglais « DC link capacitor ».

Les condensateurs 136 sont par exemple placés sous les barres omnibus 128, 130 et en particulier sous le fond 134 du support 132, leurs bornes 138, 140 traversant le fond 134 du support pour atteindre les barres omnibus 128, 130, comme cela sera décrit plus en détail par la suite.

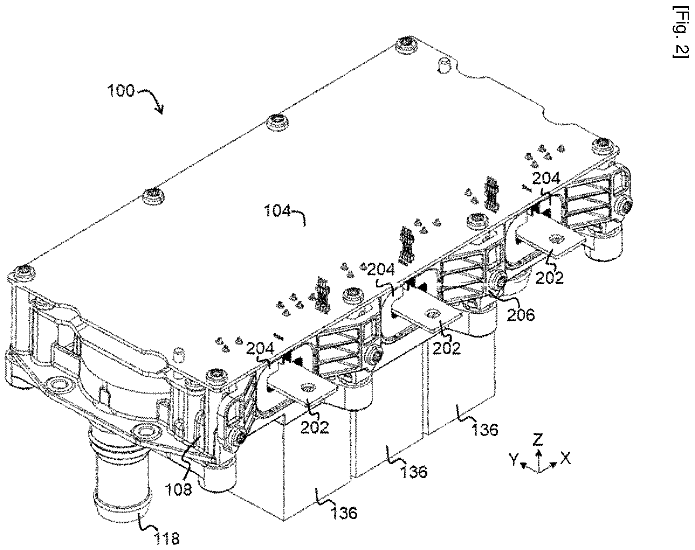

En référence à la figure 2, chaque module de puissance 102 est par exemple conçu pour effectuer une transformation entre la tension continue U_{DC} et une tension alternative respective, par exemple des tensions de phase d'une machine électrique.

Chaque module de puissance 102 présente ainsi un connecteur externe 202 conçu pour présenter cette tension alternative. Le connecteur externe 202 est par exemple sous la forme d'une barre plane, présentant de préférence une épaisseur d'au moins 0,8 mm.

La cellule de commutation 100 comporte en outre, autour de chaque connecteur externe 202, un noyau magnétique 204 d'un capteur de courant. Le noyau magnétique 204 est en boucle et présente un entrefer dans lequel un capteur à effet Hall peut par exemple être placé pour la mesure du courant.

Pour maintenir les noyaux magnétiques 204 en place, la cellule de commutation 100 comporte en outre un cadre 206 portant les noyaux magnétiques 204. Ce cadre 206 est par exemple surmoulé autour des noyaux magnétiques et fixé sur le boîtier de refroidissement 108, par exemple au moyen de vis.

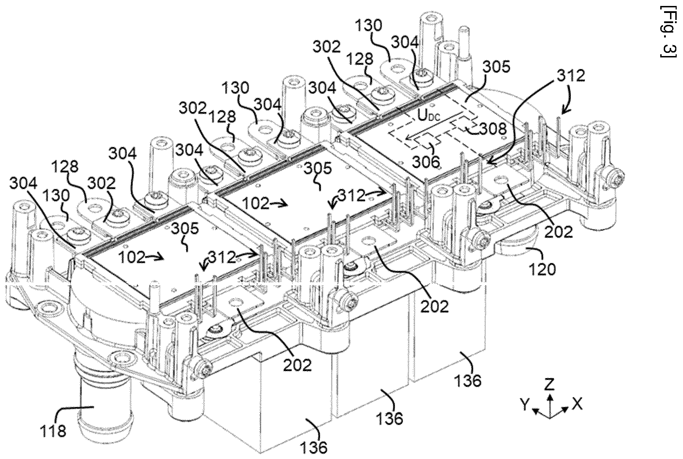

En référence à la figure 3, chaque module de puissance 102 comporte, en plus du connecteur externe alternatif 202, un connecteur externe dit positif 302 et un connecteur externe dit négatif 304, conçus pour être connectés respectivement à la barre omnibus positive 128 et à la barre omnibus négative 130. Ces connecteurs externes 302, 304 sont par exemple sous la forme de barres planes, présentant de préférence une épaisseur d'au moins 0,8 mm. Dans l'exemple illustré, deux connecteurs externes négatifs 304 sont prévus pour chaque module de puissance 102.

Pour réaliser la transformation de tension, chaque module de puissance 102 implémente par exemple un bras de commutation et comporte ainsi, dans un boîtier 305, deux interrupteurs 306, 308 connectés l'un à l'autre en un point milieu, lui-même connecté au connecteur externe alternatif 202 pour présenter la tension alternative. Le bras de commutation est connecté entre les connecteurs externes 302, 304 pour présenter la tension continue U_{DC}. Ces interrupteurs 306, 308 sont illustrés sur la figure 3 de manière schématique pour un seul des modules de puissance 102, et pas sur les autres par soucis de clarté.

Chaque interrupteur 306, 308 est de préférence un interrupteur commandable à semi-conducteur, comme par exemple un interrupteur à transistor tel qu'un transistor à effet de champ à grille métal-oxyde (de l'anglais « Metal Oxide Semiconductor Field Effect Transistor » également désigné par l'acronyme MOSFET) ou bien un transistor bipolaire à grille isolée (de l'anglais « Insulated Gate Bipolar Transistor » également désigné par l'acronyme IGBT) ou bien un transistor à effet de champ au nitrure de gallium (de l'anglais « Gallium Nitride Field Effect Transistor » également désigné par l'acronyme GaN FET).

Chaque module de puissance 102 présente en outre des broches de contrôle 312, permettant en particulier à la carte de contrôle 104 de commander la commutation des interrupteurs 306, 308. Ces broches de contrôle 312 sont pliées de manière à présenter un segment horizontal sortant du boîtier 305 du module de puissance 102 et un segment vertical s'élevant vers le haut pour atteindre la carte de contrôle 104.

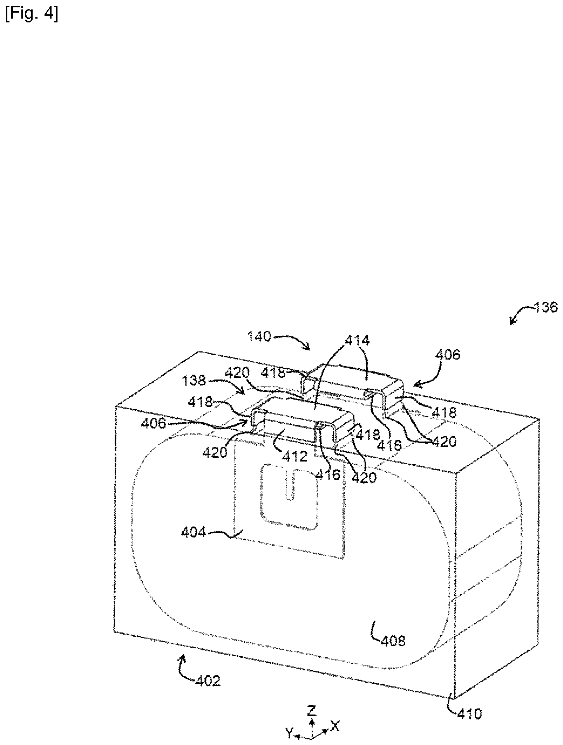

En référence à la figure 4, chaque condensateur 136 comporte un corps principal 402, chaque borne 138, 140 comportant une partie interne 404 dans le corps principal 402, et une partie externe 406 à l'extérieur du corps principal 402, se projetant de ce dernier.

Le corps principal 402 comporte par exemple un dispositif capacitif 408 et un surmoulage 410 recouvrant le dispositif capacitif 408. Le dispositif capacitif 408 est la partie du condensateur 136 où l'énergie électrique est emmagasinée. Le surmoulage 410 est par exemple en résine. La partie interne 404 de chaque borne 138, 140 s'étend ainsi par exemple dans le surmoulage 410 pour rejoindre le dispositif capacitif 408.

La partie externe 406 de chacune des bornes 138, 140 présente tout d'abord une portion de support 412. La portion de support 412 s'étend par exemple dans la continuité de la partie interne 404. La portion de support 412 est par exemple plane.

La partie externe 406 de chacune des bornes 138, 140 présente en outre une portion de connexion 414 conçue pour être soudée à l'une respective des barres omnibus 128, 130, comme cela sera décrit plus en détail par la suite. La portion de connexion 414 est attachée à la portion de support 412 par un pli et s'étend à distance du corps principal 402. La portion de connexion 414 présente une face supérieure destinée à être plaquée contre la barre omnibus 128, 130 associée, afin d'y être soudée par exemple par soudage laser.

Pour éviter que la chaleur du soudage ne traverse la portion de connexion 414 et n'atteigne le corps principal 402, la partie externe 406 de chacune des bornes 138, 140 présente en outre une portion de protection 416 attachée à la portion de connexion 414 par un pli de manière à être repliée entre la portion de connexion 414 et le corps principal 402. Par exemple, le pli entre la portion de connexion 414 et la portion de protection 416 se trouve en face du pli entre la portion de support 412 et la portion de connexion 414

La partie externe 406 de chacune des bornes 138, 140 comporte en outre par exemple au moins une portion de support auxiliaire 418 attachée à la portion de connexion 414 par un pli, de manière à se projeter vers le corps principal 402, par exemple verticalement vers le bas comme dans l'exemple illustré.

La portion de support auxiliaire 418 présente, à l'opposé de la portion de connexion 414, une extrémité au contact du corps principal 402, par exemple s'étendant dans ce dernier. Par exemple, cette extrémité est prise dans le surmoulage 410, comme dans l'exemple illustré.

Par ailleurs, l'extrémité présente de préférence un crochet 420, c'est-à-dire une excroissance. Cette excroissance est recouverte par le surmoulage 410 dans la direction de projection de la portion de support auxiliaire 418, c'est-à-dire verticalement dans l'exemple illustré. Ce crochet 420 limite le risque d'arrachement de la portion de support auxiliaire 418 hors du surmoulage 410 et le risque de déformation de la portion de connexion 414, lorsque la portion de support auxiliaire 418 est tirée parallèlement à la direction de projection.

Ainsi, la portion de connexion 414 est portée par la portion de support 412 et, le cas échéant, par la ou les portions de support auxiliaire 418.

De préférence, chaque borne 138, 140, ou du moins sa partie externe 406, est formée d'une seule plaque plane pliée.

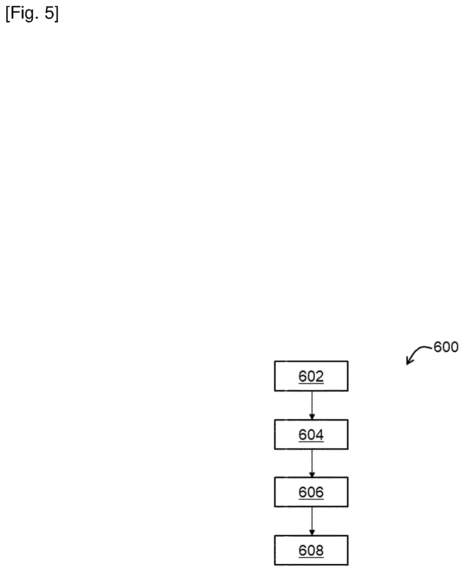

En référence à la figure 5, un exemple d'un procédé 600 de fabrication des condensateurs 136, va à présent être décrit.

Au cours d'une étape 602, les bornes 138, 140 sont obtenues avec, pour chacune d'elles, la portion de protection 416 dans la continuité de la portion de connexion 414. Par exemple, chaque borne 138, 140 obtenue est plane, par exemple découpée dans une plaque. Ainsi, avant pliage de cette plaque, la partie externe 406 et la partie interne 404 sont coplanaires, dans la continuité l'une de l'autre.

Au cours d'une étape 604, la partie externe 406 est en particulier pliée entre la portion de protection 416 et la portion de connexion 414, pour ramener la portion de protection 416 sous la portion de connexion 414. D'autres pliages de la partie externe 406 de la borne 138, 140 peuvent également être réalisés au cours de l'étape 604, par exemple pour lui donner la forme illustrée sur la figure 4. Par exemple, après le pliage de la portion protection 416 sous la portion de connexion 414, la ou les portions de support auxiliaire 418 peuvent être pliées par rapport à la portion de connexion 414. Enfin, toujours par exemple, l'ensemble de la partie interne 404 et de la portion de support 412 peut être plié par rapport à la portion de connexion 414.

Au cours d'une étape 606, les parties internes 404 des bornes 138, 140 sont fixées au dispositif capacitif 408. Ainsi, la portion de protection 416 s'étend entre la portion de connexion 414 et le corps principal 402, qui est dépourvu du surmoulage 410.

Au cours d'une étape 608, le surmoulage 410 est formé autour du dispositif capacitif 408, de la partie interne 404 de la borne 138, 140 et des crochets 420 s'ils sont prévus.

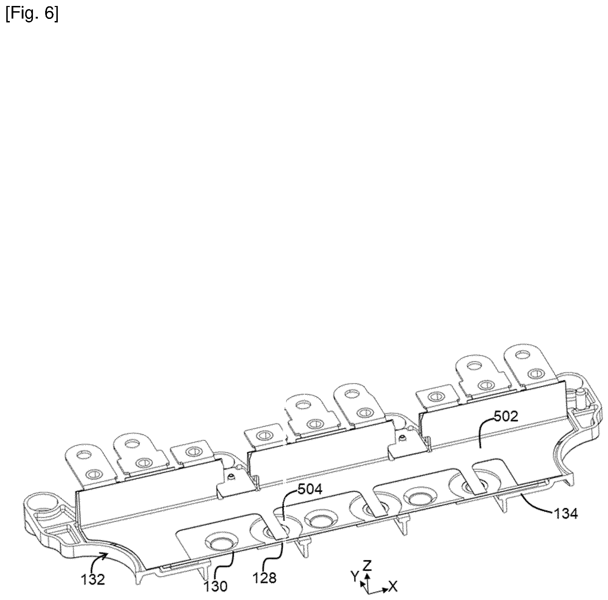

En référence à la figure 6, une couche isolante 502 est par exemple prévue au-dessus de la première plaque de la barre omnibus supérieure 130, pour l'isoler du boîtier de refroidissement 108. De même une couche isolante 504 est intercalée entre les barres omnibus 128, 130.

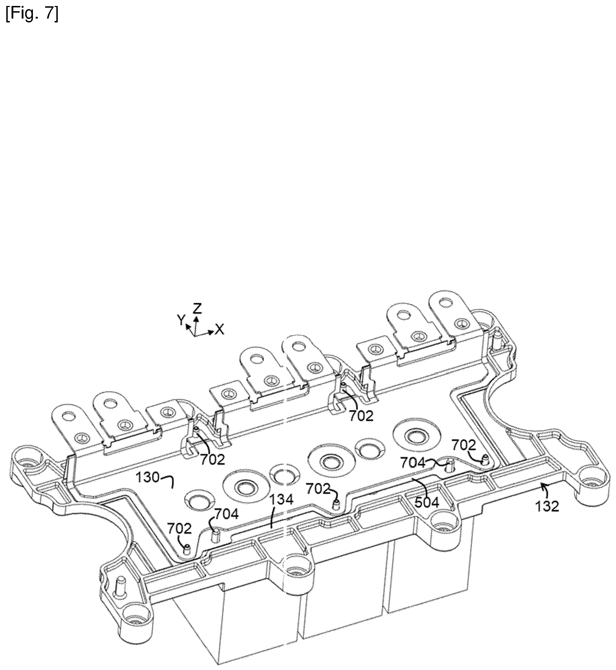

En référence à la figure 7, le support 132 présente des pions de fixation 702 respectivement reçus dans des ouvertures réalisées dans la première plaque de la barre omnibus supérieure 130. Les pions de fixation 702 se projettent par exemple vers le haut depuis le fond 134 du support 132.

Le support 132 présente en outre par exemple des pions 704 de positionnement de la barre omnibus inférieure 128. Chaque pion de positionnement 704 entre dans une ouverture respective de la première plaque de la barre omnibus inférieure 128 et permet de maintenir en place la barre omnibus inférieure 128. En particulier, les pions de positionnement 704 sont agencés de manière à maintenir la première plaque de la barre omnibus inférieure 128 en place perpendiculairement aux pions de fixation 702. Par exemple, les pions de positionnement 704 s'étendent parallèlement aux pions de fixation 702, c'est-à-dire vers le haut.

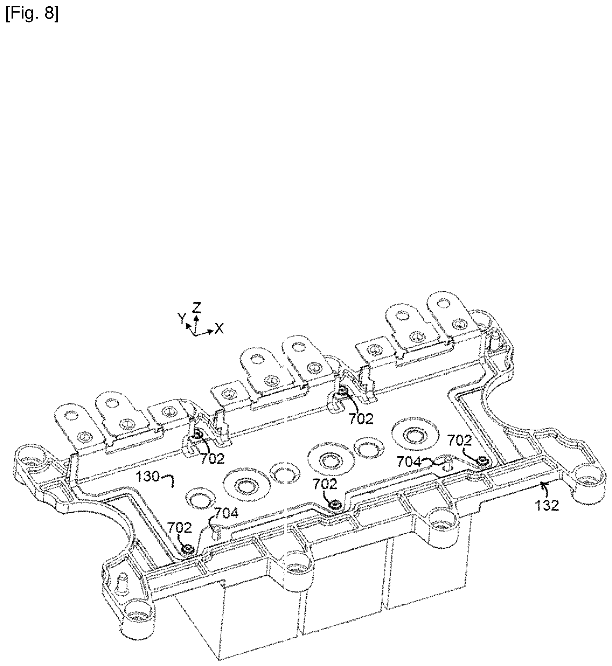

En référence à la figure 8, les pions de fixation 702 sont chacun bouterollés, pour fixer la première plaque de la barre omnibus supérieure 130 au support 132. Ce faisant, la barre omnibus inférieure 128 est maintenue en place puisque sa première plaque est enserrée entre la première plaque de la barre omnibus supérieure 130 et le fond 134 du support 132. Le bouterollage consiste à déformer, par exemple à chaud, l'extrémité de chaque pion de positionnement 704 pour former une butée pour la première plaque de la barre omnibus supérieure 130.

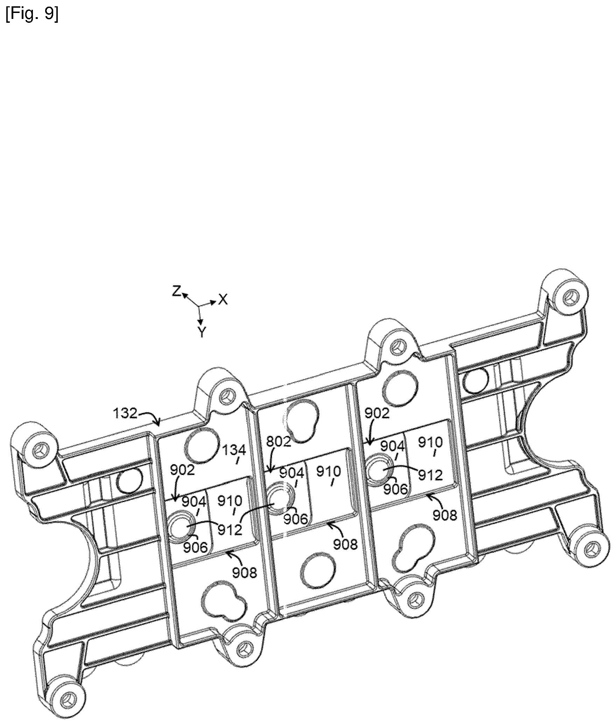

En référence à la figure 9, la première plaque de la barre omnibus inférieure 128 présente, pour chaque condensateur 136, une ouverture 902 (par exemple, une fenêtre ou bien une échancrure) laissant apparente une partie 904 de la première plaque de la barre omnibus supérieure 130. Cette partie 904 est conçue pour être connectée à l'une des bornes 138, 140 du condensateur 136 et sera appelée par la suite « partie de connexion 904 ».

La partie de connexion 904 de la barre omnibus supérieure 130 présente par exemple un bossage 906 s'étendant dans l'ouverture 902 de la première plaque de la barre omnibus inférieure 128.

Toujours pour chaque condensateur 136, le fond 134 du support 132 présente une ouverture 908 (par exemple, une fenêtre ou bien une échancrure) laissant apparente une partie 910 de la première plaque de la barre omnibus inférieure 128. Cette partie 910 est conçue pour être connectée à l'autre des bornes 138,140 du condensateur 136 et sera appelée par la suite « partie de connexion 910 ». De préférence, la partie de connexion 910 de la première plaque de la barre omnibus inférieure 128 présente une épaisseur réduite par rapport au reste de la première plaque de la barre omnibus inférieure 128, par exemple réduite d'au moins 25%. Par exemple, la partie de connexion 910 présente une épaisseur d'au plus 0,6 mm, tandis que la première plaque de la barre omnibus inférieure 128 présente, autour de la partie de connexion 910, une épaisseur d'au moins 1 mm. Cette épaisseur réduite permet de faciliter le soudage de la borne 138, 140 du condensateur 136.

L'ouverture 908 du fond 134 laisse en outre apparent l'ouverture 902 de la première plaque de la barre omnibus inférieure 128. Ainsi, la partie de connexion 904 de la première plaque de la barre omnibus supérieure 130, et en particulier le bossage 906, est apparente au travers de l'ouverture 908 du fond 134 et de l'ouverture 902 de la première plaque de la barre omnibus inférieure 128.

Le bossage 906 présente par exemple une paroi inférieure plane de connexion 912. De préférence, cette paroi de connexion 912 présente une épaisseur réduite par rapport au reste de la première plaque de la barre omnibus supérieure 130, par exemple réduite d'au moins 25%. Par exemple, la paroi de connexion 912 présente une épaisseur d'au plus 0,6 mm, tandis que la première plaque de la barre omnibus inférieure 128 présente, autour du bossage 906, une épaisseur d'au moins 1 mm. Cette épaisseur réduite permet de faciliter le soudage de la borne 138, 140 du condensateur 136.

En outre, la première plaque de la barre omnibus supérieure 130 présente, pour chaque partie de connexion 910 de la première plaque de la barre omnibus inférieure 128, une ouverture (par exemple, une fenêtre ou bien une échancrure) laissant apparente la partie de connexion 910.

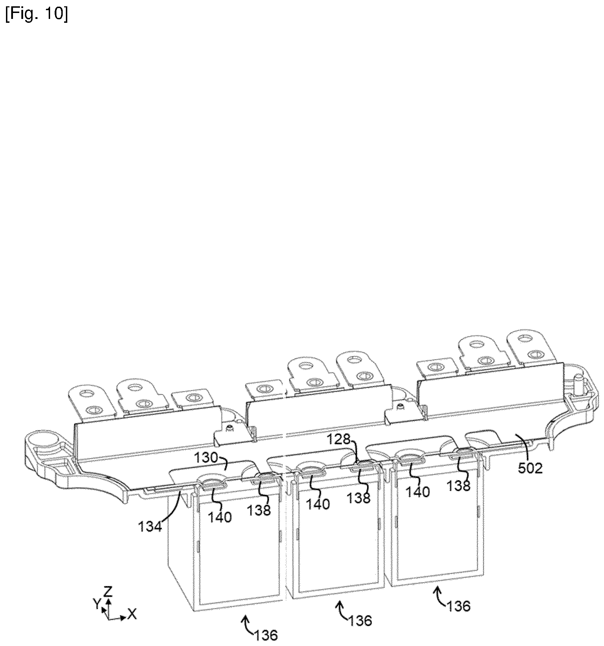

En référence à la figure 10, pour chaque condensateur 136, une des bornes (la borne négative 140 dans l'exemple illustré) est connectée, par exemple par soudage, à la partie de connexion 904 de la barre omnibus supérieure 130, et plus particulièrement à la paroi de connexion 912 du bossage 906. L'autre des bornes (la borne positive 138 dans l'exemple illustré) est connectée, par exemple par soudage, à la partie de connexion 910 de la barre omnibus inférieure 128.

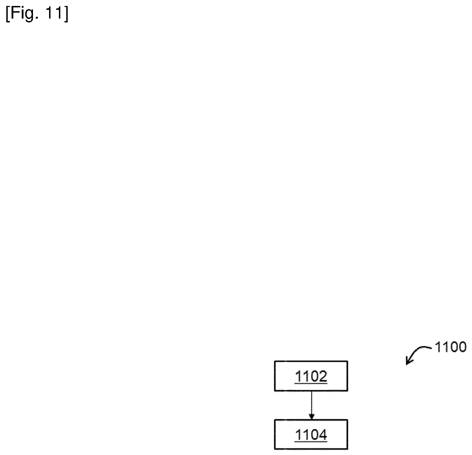

En référence à la figure 11, un exemple d'un procédé 1100 de soudage des condensateurs 136 aux barres omnibus 128, 130, va à présent être décrit.

Au cours d'une étape 1102, les bornes 138, 140 du condensateur 136 sont respectivement plaquées contre les barres omnibus 128, 130. Par exemple, les portions de connexion 414 des bornes 138, 140 sont respectivement plaquées contre la paroi de connexion 912 du bossage 906 de la barre omnibus supérieure 130 et contre la partie de connexion 910 de la barre omnibus inférieure 128. De préférence, le plaquage est plan sur plan, par exemple sur une plaque d'au moins 20 mm².

Au cours d'une étape 1104, pour souder chaque borne 138, 140 à la barre omnibus 128, 130 contre laquelle cette borne 138, 140 est plaquée, un faisceau laser est envoyé sur la barre omnibus 128, 130, à l'opposé de la borne 138, 140 plaquée.

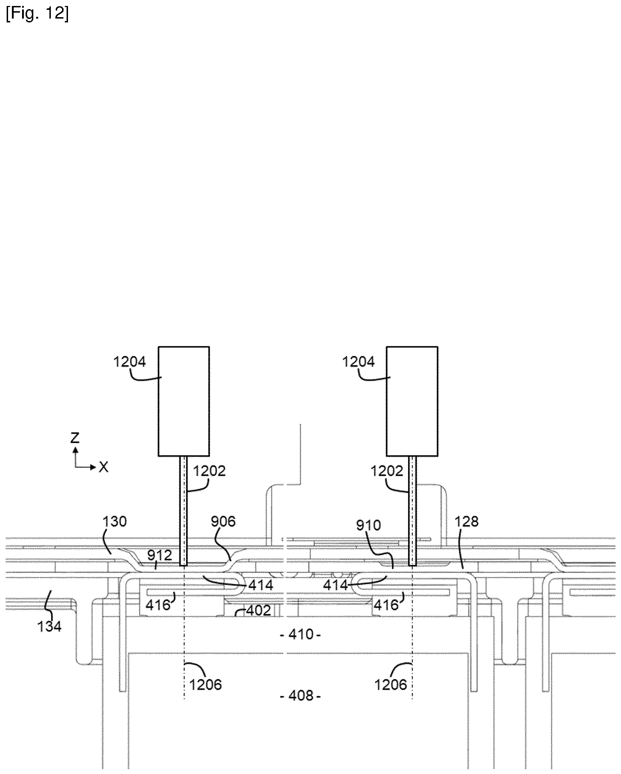

En référence à la figure 12, le faisceau laser 1202 est envoyé par un laser 1204 selon une direction 1206 passant successivement par la barre omnibus 128, 130, la portion de connexion 414 de la borne 138, 140 plaquée, la portion de protection 416 de la borne 138, 140 plaquée et le corps principal 402 du condensateur 136. La direction 1206 est ainsi perpendiculaire à la portion de connexion 414.

En outre, l'existence d'une ouverture dans la première plaque de la barre omnibus supérieure 130 permet au faisceau laser d'atteindre directement la partie de connexion 910 de la première plaque de la barre omnibus inférieure 128 pour pouvoir souder cette partie de connexion 910 à la borne du condensateur 136 contre laquelle elle est plaquée.

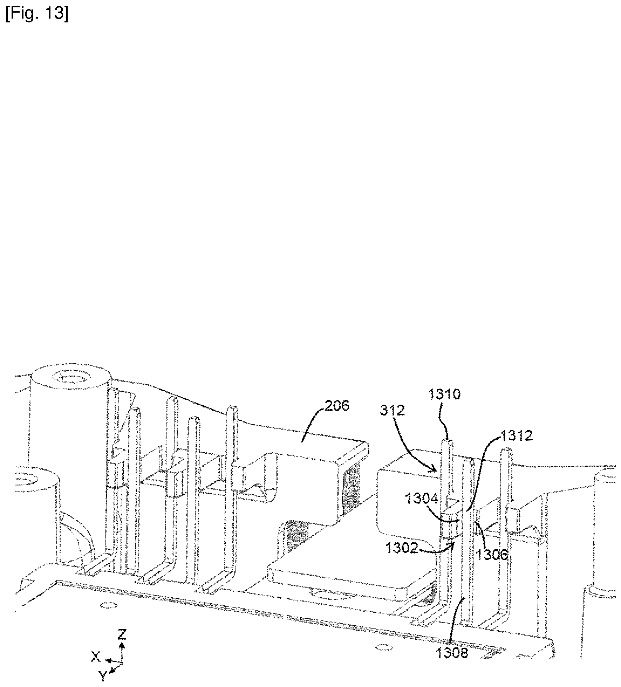

En référence à la figure 13, il est prévu dans le cadre 206, pour chaque broche de contrôle 312, une encoche 1302 de positionnement de cette broche de contrôle 312. Par souci de clarté, cette encoche de positionnement 1302 n'est référencée sur les figures que pour une des broches de contrôle.

Grâce à l'encoche de positionnement, la position de la broche de contrôle 312 peut être assurée, ce qui facilite la connexion de la broche de contrôle 312 avec la carte électronique 104. En outre, lorsque cette connexion se fait par insertion en force, l'encoche de positionnement 1302 réduit le risque que la broche de contrôle 312 se torde lors de son insertion en force.

Par exemple, l'encoche de positionnement 1302 présente deux parois 1304, 1306 faisant entre elles un angle compris entre 80° et 100°, de préférence entre 90° et 95°, encore de préférence de 90°, de manière à bien positionner la broche de contrôle 312. La broche de contrôle 312 présente ainsi un segment d'extrémité 1308 terminé par une pointe 1310. La broche de contrôle 312 est conçue pour être insérée dans un trou de réception respectif de la carte électronique 104 par sa pointe 1310. Ce segment d'extrémité 1308 est par exemple droit (vertical dans l'exemple illustré) et présente une partie de positionnement 1312 ayant une longueur d'au moins 5 mm et s'étendant sur toute sa longueur à au plus 0,5 mm de chacune des parois 1304, 1306 de l'encoche de positionnement 1302.

La broche de contrôle 312 illustrée sur la figure 13 est ainsi par exemple conçue pour être insérée de manière libre (pas en force) dans le trou de réception, puis soudée à la carte électronique 104.

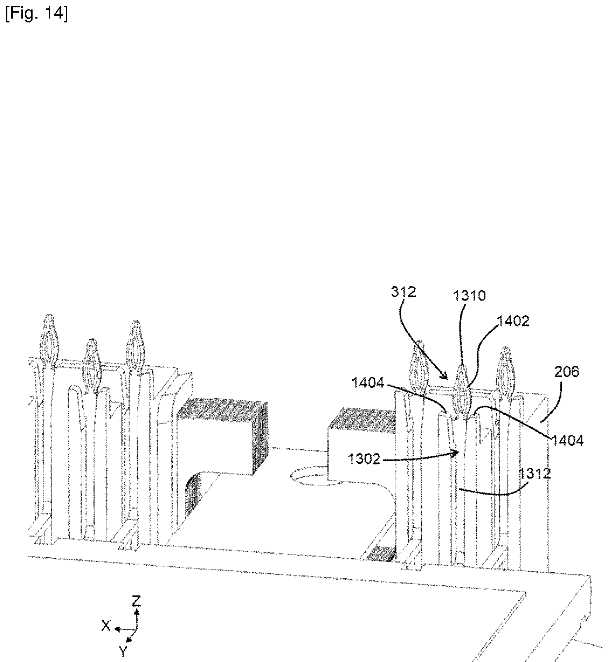

En référence à la figure 14, un autre exemple de réalisation est représenté.

Dans cet autre exemple, la broche de contrôle 312 est par exemple conçue pour être insérée en force dans le trou de réception de la carte électronique 104.

Pour cela, le segment d'extrémité 1308 présente une partie d'insertion en force 1402 présentant une largeur plus grande que le trou de réception de la carte électronique. Par exemple, la partie d'insertion en force 1402 comporte deux tiges se rejoignant à leurs extrémités et séparées en leur milieu par un espace.

De préférence, le cadre 206 présente au moins un chanfrein 1404 de guidage de la broche de contrôle 312, et plus particulièrement de son coude, vers l'encoche de positionnement 1302. Ainsi, le chanfrein 1404 facilite l'insertion, en particulier verticalement, de la broche de contrôle 312 dans l'encoche de positionnement 1302.

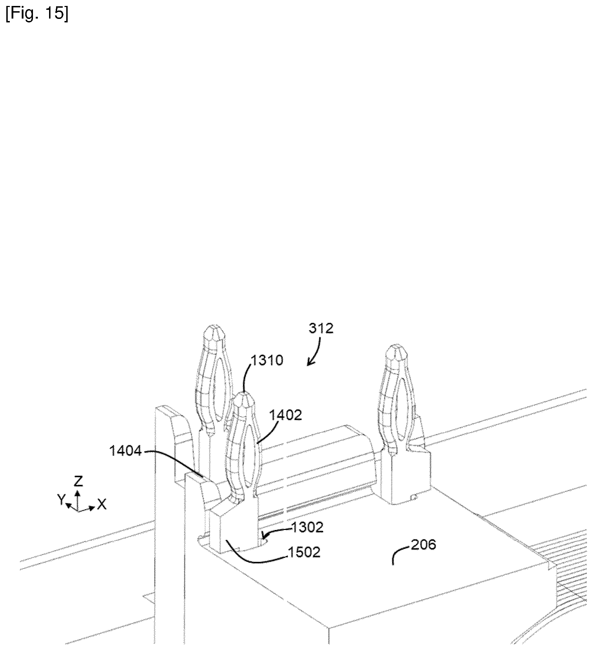

En référence à la figure 15, le segment d'extrémité 1308 présente en outre une excroissance 1502 se projetant perpendiculairement à la direction verticale de manière à s'étendre au-dessus de la pièce de support selon la direction verticale, de préférence, à moins de 0,1 mm du cadre 206 selon la direction verticale, de préférence au contact du cadre 206.

Ainsi, lors de l'insertion en force de la broche de contrôle 312, l'excroissance 1502 vient en butée contre la pièce de support ce qui permet de fournir à la broche un contre effort. Cela évite de devoir placer provisoirement une butée amovible pendant l'opération d'insertion en force. En particulier, l'absence de cette butée provisoire permet de grandement simplifier l'outillage utilisé pour réaliser l'insertion en force.

Cette excroissance 1502 est par exemple située entre la partie d'insertion en force 1402 et la partie de positionnement 1312.

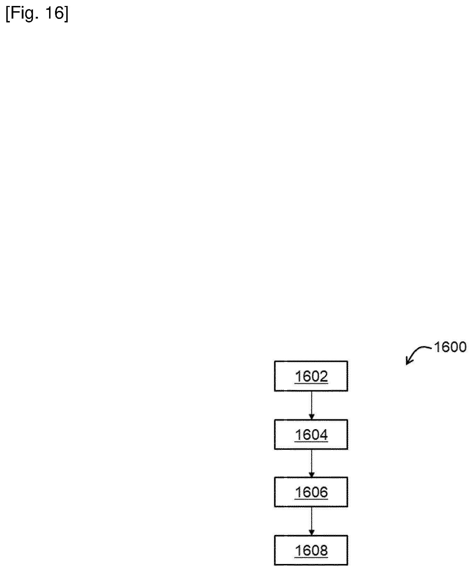

En référence à la figure 16, un procédé 1600 de fabrication de la cellule de commutation 100 comporte par exemple les étapes suivantes.

Au cours d'une étape 1602, le module de puissance 102 est obtenu avec les broches de contrôle 312 sortant du boîtier 305.

Au cours d'une étape 1604, la carte électronique 104 est obtenue, avec un trou de réception de chaque broche de contrôle 312.

Au cours d'une étape 1606, le module de puissance 102 est fixé au boîtier de refroidissement portant le cadre 206. Lors de cette fixation, le module de puissance 102 est descendu verticalement, de sorte que les broches de contrôle 312, en particulier guidées par les chanfreins 1502, entrent respectivement dans les encoches de positionnement 1302.

Au cours d'une étape 1608, la carte électronique 104 est descendue verticalement vers les modules de puissance 102, de manière à ce que les broches de contrôle s'étendant dans l'encoche de positionnement, s'insèrent respectivement dans les trous de réception.

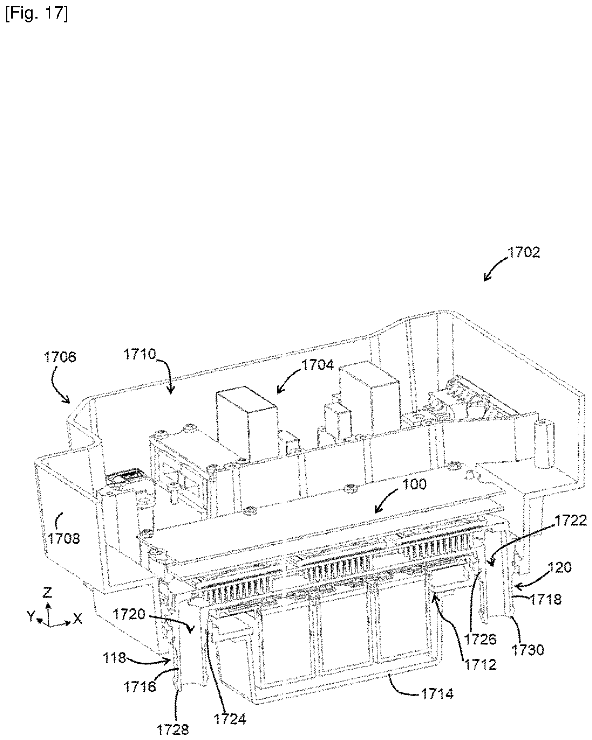

En référence à la figure 17, la cellule de commutation 100 est par exemple conçue pour faire partie d'un système électrique, par exemple un onduleur 1702.

L'onduleur 1702 comporte par exemple un filtre de compatibilité électromagnétique (CEM) 1704 connecté entre les deux barres omnibus 128, 130 et un boîtier, dit boîtier général 1706, dans lequel sont placés le filtre CEM 1704 et la cellule de commutation 100.

Le boîtier général 1706 comporte par exemple une partie principale 1708 présentant une ouverture supérieure 1710 et un couvercle (non représenté) conçu pour fermer cette ouverture supérieure 1710. Le boîtier général 1706 comporte en outre par exemple une ouverture inférieure 1712 de passage des condensateurs 136 et un capot 1714 pour fermer cette ouverture inférieure 1712.

Le conduit d'entrée 118 et le conduit de sortie 120 présentent respectivement deux segments 1716, 1718 se projetant sensiblement parallèlement l'un à l'autre dans le même sens.

Le boîtier général 1706 présente alors deux ouvertures 1720, 1722 de passage respectivement des segments 1716, 1718. Chaque ouverture 1720, 1722 présente par exemple un joint d'étanchéité 1724, 1726 destiné à coopérer avec le segment 1716, 1718 inséré.

Les segments 1716, 1718 présentent ainsi, à l'extérieur du boîtier général 1706, des extrémités 1728, 1730 respectives conçues pour être raccordées à un système de circulation du liquide de refroidissement. Ces extrémités 1728, 1730 peuvent par exemple présenter des chanfreins d'entrée. Ainsi, le raccordement du circuit de refroidissement est réalisé à l'extérieur du boîtier général 1706, de manière à réduire les risques de fuite dans le boîtier général en cas de mauvaise étanchéité de ce raccordement.

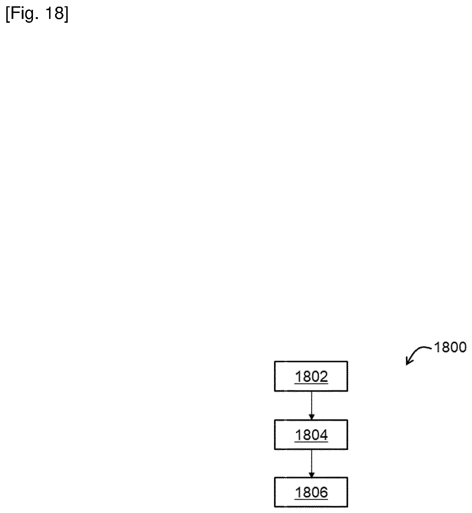

En référence à la figure 18, un procédé 1800 d'assemblage du système électrique 1702 va à présent être décrit.

Au cours d'une étape 1802, la cellule de commutation 100 est insérée par l'ouverture supérieure 1710 dans le boîtier général 1706. À cette occasion, les segments 1716, 1718 des conduits 118, 120 sont insérés respectivement dans les ouvertures 1720, 1722 ménagées dans la partie principale 1708 pour guider le positionnement de la cellule de commutation 100 à l'intérieur du boîtier principal 1706.

Au cours d'une étape 1804, la cellule de commutation 100 est fixée à la partie principale 1708 du boîtier général 1706, par exemple par vissage.

Au cours d'une étape 1806, l'ouverture supérieure 1710 de la partie principale 1708 est fermée par le couvercle (non représenté) du boîtier général 1706.

En conclusion, on notera que l'invention n'est pas limitée aux modes de réalisation décrits précédemment. Il apparaîtra en effet à l'homme de l'art que diverses modifications peuvent être apportées aux modes de réalisation décrits ci-dessus, à la lumière de l'enseignement qui vient de lui être divulgué.

En particulier, l'ordre des étapes des procédés décrits précédemment pourrait être changé en tout ordre techniquement possible.

Dans la présentation détaillée de l'invention qui est faite précédemment, les termes utilisés ne doivent pas être interprétés comme limitant l'invention aux modes de réalisation exposés dans la présente description, mais doivent être interprétés pour y inclure tous les équivalents dont la prévision est à la portée de l'homme de l'art en appliquant ses connaissances générales à la mise en œuvre de l'enseignement qui vient de lui être divulgué, sous réserve d'être couverts par les revendications.

## Revendications

1. Cellule de commutation (100) comportant :
- des modules de puissance (102) ;
- une première barre omnibus (130), dite barre omnibus supérieure, et une deuxième barre omnibus (128), dite barre omnibus inférieure, connectées à chacun des modules de puissance (102) afin de distribuer à ces derniers une tension continue (U_{DC}), la barre omnibus supérieure et la barre omnibus inférieure comprenant chacune une première plaque ; et,
- au moins un condensateur (136) avec deux bornes respectivement soudées à la première (130) et à la deuxième barre omnibus (128) ;
dans laquelle la barre omnibus supérieure (130) et la barre omnibus inférieure (128) sont empilées l'une sur l'autre et **caractérisée en ce qu'**elle comporte un support
(132) de la barre omnibus supérieure (130) et inférieure (128) comportant un fond (134) sur lequel s'étendent les premières plaques des barres omnibus (128, 130) empilées, **en ce que** la première plaque de la barre omnibus inférieure (128) présente une ouverture (902) laissant apparente une partie, dite de connexion (904), de la première plaque de la barre omnibus supérieure (130) et **en ce que** le fond (134) présente une ouverture (908) laissant apparente une partie, dite de connexion (910), de la première plaque de la barre omnibus inférieure (128) et au moins une partie de l'ouverture (902) de la première plaque de la barre omnibus inférieure (128), afin de connecter, d'une part, une première borne (138) du condensateur (136) à la partie de connexion (910) de la barre omnibus inférieure (128) au travers de l'ouverture (908) du fond (134) et, d'autre part, une deuxième borne (140) du condensateur (136) à la partie de connexion (904) de la barre omnibus supérieure (130) au travers de l'ouverture (908) du fond (134) et de l'ouverture (902) de la barre omnibus inférieure (128).

2. Cellule de commutation (100) selon la revendication 1, dans laquelle la partie de connexion (910) de la première plaque de la barre omnibus inférieure (128) présente une épaisseur réduite par rapport au reste de la première plaque de la barre omnibus inférieure (128).

3. Cellule de commutation (100) selon la revendication 1 ou 2, dans laquelle la première plaque de la barre omnibus supérieure (130) présente un bossage (906) s'étendant dans l'ouverture (902) de la première plaque de la barre omnibus inférieure (128).

4. Cellule de commutation (100) selon la revendication 3, dans laquelle le bossage (906) présente une paroi inférieure plane de connexion (912) présentant une épaisseur réduite par rapport au reste de la première plaque de la barre omnibus supérieure (130).

5. Cellule de commutation (100) selon l'une quelconque des revendications 1 à 4, dans laquelle le support (132) présente un pion de fixation (702), et dans laquelle la première plaque de la barre omnibus supérieure (130) présente une ouverture de réception du pion de fixation (702), ce dernier étant bouterollé pour fixer la première plaque de la barre omnibus (130) au support (132).

6. Cellule de commutation (100) selon la revendication 5, dans laquelle la première plaque de la barre omnibus inférieure (128) est maintenue entre la première plaque de la barre omnibus supérieure (130) et le support (132).

7. Cellule de commutation (100) selon l'une quelconque des revendications 1 à 6, dans laquelle le support (132) présente un pion (704) de positionnement de la première plaque de la barre omnibus inférieure (128).

8. Cellule de commutation (100) selon l'une quelconque des revendications 1 à 7 comprenant en outre un circuit (106) de refroidissement des modules de puissance, ledit circuit (106) de refroidissement comportant un boîtier de refroidissement (108) définissant un canal (110) d'écoulement d'un liquide de refroidissement, le boîtier de refroidissement (108) présentant une face supérieure de refroidissement (112) et une face inférieure de refroidissement (113), toutes les deux refroidies par l'écoulement du liquide de refroidissement dans le canal (110), les modules de puissance (102) étant plaqués contre la face supérieure de refroidissement (112) pour être refroidis et dans lequel la première plaque de la barre omnibus supérieure (130) est en contact thermique avec la face inférieure de refroidissement (113).

9. Onduleur comprenant une cellule de commutation selon l'une quelconque des revendications 1 à 8.

10. Engin de mobilité comprenant une cellule de commutation selon l'une quelconque des revendications 1 à 8 ou un onduleur selon la revendication 9.

## Patentansprüche

1. Schaltzelle (100), aufweisend:
• Leistungsmodule (102);
• eine erste Sammelschiene (130), genannt obere Sammelschiene, und eine zweite Sammelschiene (128), genannt untere Sammelschiene, die mit jedem der Leistungsmodule (102) verbunden sind, um an diese eine Gleichspannung (UDC) zu verteilen, wobei die obere Sammelschiene und die untere Sammelschiene jeweils eine erste Platte aufweisen; und
• mindestens einen Kondensator (136) mit zwei Anschlüssen, die jeweils an die erste (130) und an die zweite Sammelschiene (128) geschweißt sind; wobei die obere Sammelschiene (130) und die untere Sammelschiene (128) übereinander gestapelt sind, und **dadurch gekennzeichnet, dass** sie einen Träger (132) für die obere Sammelschiene (130) und die untere Sammelschiene (128) aufweist, der einen Boden (134) aufweist, auf dem sich die ersten Platten der gestapelten Sammelschienen (128, 130) erstrecken, dass die erste Platte der unteren Sammelschiene (128) eine Öffnung (902) aufweist, die einen Teil, genannt Anschlussteil (904), der ersten Platte der oberen Sammelschiene (130) freilegt, und dass der Boden (134) eine Öffnung (908) aufweist, die einen Teil, genannt Anschlussteil (910), der ersten Platte der unteren Sammelschiene (128) und mindestens einen Teil der Öffnung (902) der ersten Platte der unteren Sammelschiene (128) freilegt, um einerseits einen ersten Anschluss (138) des Kondensators (136) mit dem Anschlussteil (910) der unteren Sammelschiene (128) durch die Öffnung (908) des Bodens (134) hindurch und andererseits einen zweiten Anschluss (140) des Kondensators (136) mit dem Anschlussteil (904) der oberen Sammelschiene (130) durch die Öffnung (908) des Bodens (134) und die Öffnung (902) der unteren Sammelschiene (128) hindurch zu verbinden.

2. Schaltzelle (100) nach Anspruch 1, wobei der Anschlussteil (910) der ersten Platte der unteren Sammelschiene (128) eine reduzierte Dicke im Vergleich zum Rest der ersten Platte der unteren Sammelschiene (128) aufweist.

3. Schaltzelle (100) nach Anspruch 1 oder 2, wobei die erste Platte der oberen Sammelschiene (130) einen Vorsprung (906) aufweist, der sich in die Öffnung (902) der ersten Platte der unteren Sammelschiene (128) erstreckt.

4. Schaltzelle (100) nach Anspruch 3, wobei der Vorsprung (906) eine ebene untere Anschlusswand (912) aufweist, die eine reduzierte Dicke im Vergleich zum Rest der ersten Platte der oberen Sammelschiene (130) aufweist.

5. Schaltzelle (100) nach einem der Ansprüche 1 bis 4, wobei der Träger (132) einen Befestigungsstift (702) aufweist, und wobei die erste Platte der oberen Sammelschiene (130) eine Öffnung zur Aufnahme des Befestigungsstifts (702) aufweist, wobei letzterer vernietet ist, um die erste Platte der Sammelschiene (130) an dem Träger (132) zu befestigen.

6. Schaltzelle (100) nach Anspruch 5, wobei die erste Platte der unteren Sammelschiene (128) zwischen der ersten Platte der oberen Sammelschiene (130) und dem Träger (132) gehalten wird.

7. Schaltzelle (100) nach einem der Ansprüche 1 bis 6, wobei der Träger (132) einen Positionierungsstift (704) zum Positionieren des ersten Blechs der unteren Sammelschiene (128) aufweist.

8. Schaltzelle (100) nach einem der Ansprüche 1 bis 7, ferner aufweisend einen Kühlkreislauf (106) zum Kühlen der Leistungsmodule, wobei der Kühlkreislauf (106) ein Kühlgehäuse (108) aufweist, das einen Strömungskanal (110) für eine Kühlflüssigkeit definiert, wobei das Kühlgehäuse (108) eine obere Kühlfläche (112) und eine untere Kühlfläche (113) aufweist, die beide durch das Strömen der Kühlflüssigkeit im Kanal (110) gekühlt werden,wobei die Leistungsmodule (102) gegen die obere Kühlfläche (112) gedrückt werden, um gekühlt zu werden, und wobei die erste Platte der oberen Sammelschiene (130) in thermischem Kontakt mit der unteren Kühlfläche (113) steht.

9. Wechselrichter, aufweisend eine Schaltzelle nach einem der Ansprüche 1 bis 8.

10. Mobilitätsfahrzeug, aufweisend eine Schaltzelle nach einem der Ansprüche 1 bis 8 oder einen Wechselrichter nach Anspruch 9.

## Claims

1. A switching cell (100) comprising:
• power modules (102);
• a first busbar (130), referred to as the upper busbar, and a second busbar (128), referred to as the lower busbar, connected to each of the power modules (102) in order to distribute a direct current voltage (UDC) to the latter, the upper busbar and the lower busbar each comprising a first plate; and,
• at least one capacitor (136) with two terminals respectively welded to the first (130) and to the second busbar (128); wherein the upper busbar (130) and the lower busbar (128) are stacked on top of each other, and **characterized in that** it comprises a support (132) for the upper busbar (130) and lower busbar (128) comprising a base (134) on which the first plates of the stacked busbars (128, 130) extend, **in that** the first plate of the lower busbar (128) has an opening (902) exposing a part, referred to as the connection part (904), of the first plate of the upper busbar (130), and **in that** the base (134) has an opening (908) exposing a part, referred to as the connection part (910), of the first plate of the lower busbar (128) and at least a part of the opening (902) of the first plate of the lower busbar (128), in order to connect, on the one hand, a first terminal (138) of the capacitor (136) to the connection part (910) of the lower busbar (128) through the opening (908) of the base (134) and, on the other hand, a second terminal (140) of the capacitor (136) to the connection part (904) of the upper busbar (130) through the opening (908) of the base (134) and the opening (902) of the lower busbar (128).

2. The switching cell (100) according to claim 1, wherein the connection part (910) of the first plate of the lower busbar (128) has a reduced thickness compared to the rest of the first plate of the lower busbar (128).

3. The switching cell (100) according to claim 1 or 2, wherein the first plate of the upper busbar (130) has a boss (906) extending into the opening (902) of the first plate of the lower busbar (128).

4. The switching cell (100) according to claim 3, wherein the boss (906) has a planar lower connection wall (912) having a reduced thickness compared to the rest of the first plate of the upper busbar (130).

5. The switching cell (100) according to any one of claims 1 to 4, wherein the support (132) has a fixing pin (702), and wherein the first plate of the upper busbar (130) has an opening for receiving the fixing pin (702), the latter being riveted to fix the first plate of the busbar (130) to the support (132).

6. The switching cell (100) according to claim 5, wherein the first plate of the lower busbar (128) is held between the first plate of the upper busbar (130) and the support (132).

7. The switching cell (100) according to any one of claims 1 to 6, wherein the support (132) has a positioning pin (704) for positioning the first plate of the lower busbar (128).

8. The switching cell (100) according to any one of claims 1 to 7, further comprising a cooling circuit (106) for cooling the power modules, said cooling circuit (106) comprising a cooling housing (108) defining a flow channel (110) for a cooling liquid, the cooling housing (108) having an upper cooling face (112) and a lower cooling face (113), both cooled by the flow of the cooling liquid in the channel (110), the power modules (102) being pressed against the upper cooling face (112) in order to be cooled, and wherein the first plate of the upper busbar (130) is in thermal contact with the lower cooling face (113).

9. An inverter comprising a switching cell according to any one of claims 1 to 8.

10. A mobility vehicle comprising a switching cell according to any one of claims 1 to 8 or an inverter according to claim 9.
